Europäisches Patentamt

European Patent Office

Office européen des brevets

(11) Publication number: **0 083 238**
**B1**

(12) **EUROPEAN PATENT SPECIFICATION**

(45) Date of publication of patent specification: **27.07.88**

(51) Int. Cl.⁴: **H 03 L 7/08**, H 03 B 19/18

(21) Application number: **82306962.0**

(22) Date of filing: **24.12.82**

(54) **A high frequency generator.**

(30) Priority: **29.12.81 JP 212127/81**

(43) Date of publication of application:
**06.07.83 Bulletin 83/27**

(45) Publication of the grant of the patent:
**27.07.88 Bulletin 88/30**

(84) Designated Contracting States:
**DE FR GB IT NL**

(56) References cited:
**US-A-3 401 355**
**US-A-4 208 635**
**US-A-4 297 648**

**PATENTS ABSTRACTS OF JAPAN, vol. 5, no.
19, (E-44) (691) February 4, 1981**

**PATENTS ABSTRACTS OF JAPAN, vol. 5, no.
129, (E-70) (801) August 19, 1981
MOTOROLA SEMICONDUCTOR PRODUCTS
INC. Application Note 147, PHOENIX
ARIZONA,(US) G. SCHAFFNER: "High-power
varactor diodes: Theory and Application."
pages 1-8**

(73) Proprietor: **FUJITSU LIMITED
1015, Kamikodanaka Nakahara-ku
Kawasaki-shi Kanagawa 211 (JP)**

(72) Inventor: **Yano, Yasuhiro c/o FUJITSU LIMITED
Patent Department 1015 Kamikodanaka
Nakahara-ku Kawasaki-shi Kanagawa 211 (JP)**
Inventor: **Umino, Isamu c/o FUJITSU LIMITED
Patent Department 1015 Kamikodanaka
Nakahara-ku Kawasaki-shi Kanagawa 211 (JP)**
Inventor: **Ohsawa, Zenichi c/o FUJITSU
LIMITED
Patent Department 1015 Kamikodanaka
Nakahara-ku Kawasaki-shi Kanagawa 211 (JP)**
Inventor: **Ozaki, Takayuki c/o FUJITSU LIMITED
Patent Department 1015 Kamikodanaka
Nakahara-ku Kawasaki-shi Kanagawa 211 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

The present invention relates to a high frequency generator.

A high frequency generator having a structure in which signals of predetermined frequency are obtained by multiplying output signals of a high frequency oscillator comprising a frequency stabilizing circuit such as Phase Lock Loop (PLL) is known. Such a high frequency generator is required to keep its output 'off' for a while after a power switch has been turned on, because abnormal frequencies may initially be generated until frequency stabilization achieves a steady state through operation of the frequency stabilizing circuit.

Two methods have been used for keeping the output of a high frequency generator "off". In one method an ON/OFF circuit such as a diode switch using a PIN diode, or a coaxial relay, is inserted into the output of the generator. In the other method, output is kept 'off' through suspension of operation by changing the bias of an amplifier used in an output circuit.

The former method has disadvantages in that the circuit structure becomes complicated because an additional ON/OFF circuit is provided and moreover in that signal loss therein is inevitable. The latter method cannot be applied to a structure not using an amplifier.

In either method, output is turned off at the output frequency stage and consideration must be given to factors such as shielding in order to ensure a sufficient attenuation of the output, resulting in a tendency towards increased cost.

JP—A—56 66 906 discloses a frequency multiplying circuit in which the bias of a varactor is varied between a state offering good frequency multiplying efficiency (in a "synchronised" condition of the multiplying circuit) and a state in which a forward bias current is applied to the varactor to reduce its frequency multiplying efficiency.

US—A—3 401 355 discloses a step recovery diode in a frequency multiplier in which the diode is mounted in a resonant cavity and a continuous wave output is provided. Biassing of the step recovery diode to obtain maximum output and for phase control of the output signal is discussed.

According to the present invention there is provided a high frequency generator, comprising

generating means for generating a signal of a first frequency, and

multiplier means, having an input terminal operatively connected to the generating means, for providing a frequency-multiplied signal, of a second frequency, from the signal of the first frequency, the multiplier means comprising a diode, operatively connected to the input terminal, for providing harmonic frequency signals, including a signal of the second frequency, from said signal of the first frequency, bias voltage control means for controlling bias voltage applied to the diode, and output means characterised in that

the diode is a step recovery diode,

the bias voltage control means operate to turn off selectively the frequency-multiplied signal, by turning off the step recovery diode so that it no longer provides harmonic frequency signals including a signal of the second frequency, and in that

the output means is a waveguide of uniform width, open at one end, having a specified resonant frequency, with the step recovery diode mounted in the waveguide at its other end.

This invention provides a device for generating high frequency signals such as microwave or milliwave (millimetre wavelength) signals and particularly offers a means for controlling the output of a high frequency generator having multiplier means using a step recovery diode for handling the output of an oscillator.

The present invention provides means for reliably turning off a high frequency output using only a simple structure, by controlling a bias to be applied to a multiplying means, using a step recovery diode, in high frequency generating means comprising an oscillator and a multiplier.

The invention provides a high frequency generator which is capable of attenuating and turning "off" its output, by providing a multiplier means connected to the output of oscillator by a step recovery diode and by controlling a bias voltage to be applied to this diode.

Reference is made, by way of example, to the accompanying drawings, in which:—

Figure 1 is a schematic block diagram indicating the structure of a high frequency generator in accordance with an embodiment of this invention,

Figure 2 is a schematic circuit diagram illustrating a structure of a multiplier means in accordance with an embodiment of the invention,

Figure 3 is a schematic circuit diagram illustrating an alternative structure of a multiplier means not using a waveguide in accordance with the invention,

Figure 4 illustrates waveforms of an input signal for multiplier means and an output signal of a step recovery diode,

Figure 5(a) and (b) are schematic circuit diagrams illustrating respective structures for bias voltage controlling means, and

Figure 6 is a graph illustrating a bias voltage controlling characteristic of a multiplier means.

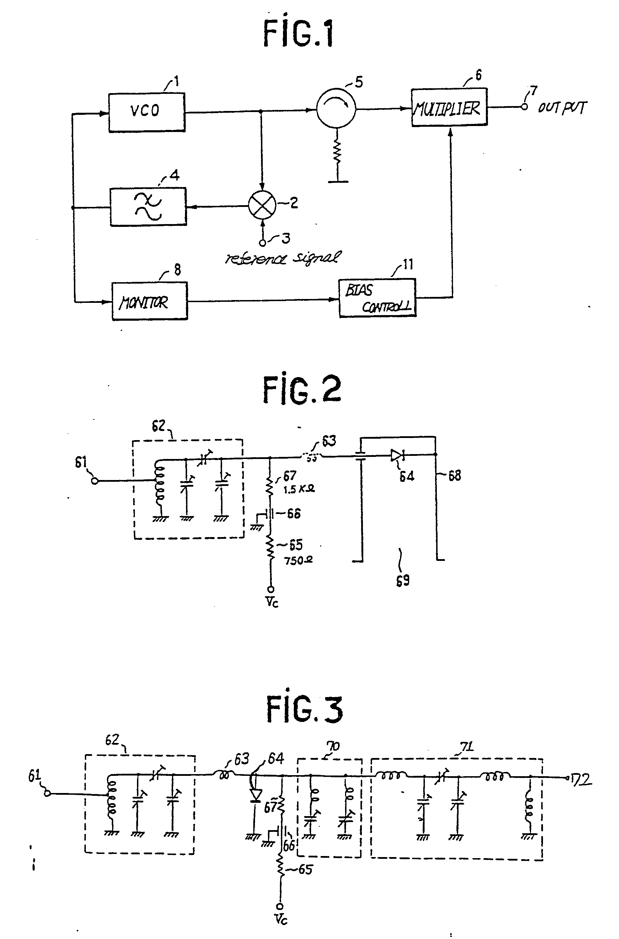

In Figure 1, 1 is a voltage controlled oscillator (referred to as a VCO). An output of this VCO is applied to a harmonics mixer 2 and is compared with a reference frequency signal input from a terminal 3. An error signal output of the harmonics mixer 2 is fed back to the VCO 1 through a loop filter 4, thus forming a phase lock loop (referred to as a PLL). An output of the VCO 1 is applied to multiplier means 6 via a circulator 5, forming an isolator, and is multiplied to provide a desired high frequency output at an output terminal 7. 8 is a monitoring circuit which monitors synchronisation of the PLL, taking an output of the loop filter 4 for this purpose. When the output of the monitoring circuit 8 becomes OFF, (i.e.

when non-synchronisation of the PLL is detected) bias controlling means 11 generates a specified control voltage and this voltage is applied to the multiplier means 6. Thereby a high frequency output of multiplier means 6 is turned OFF.

The PLL circuit consisting of the VCO 1, harmonics mixer 2 and loop filter 4 is already known. The oscillation frequency $f_o$ of the VCO 1 is controlled by a signal applied thereto via the loop filter 4. On the other hand, since the reference frequency signal $f_R = f_o/n_1$, having high frequency stability being generated by a crystal oscillator for example, is being applied to the terminal 3, the harmonics mixer 2 compares the phases of the reference $(f_o)$ $n_1$ times the frequency of the reference frequency signal and an output signal $(f_o)$ of the VCO 1 and generates an error signal output. An error signal output of the harmonics mixer 2 passes the loop filter 4 and is fed back to the VCO 1 as a high frequency control voltage. Thereby, control is carried out in the PLL circuit so that the error signal output from the harmonics mixer 2 approaches zero, realizing stabilisation of the oscillation frequency of VCO 1.

An oscillation output of VCO 1 is input to the multiplier means 6 via the circulator 5. The circulator is provided for reducing the load effect of multiplier means 6 on the VCO 1. For example, when the input frequency $f_o$ is about 2 GHz, the multiplier means 6 uses a step recovery diode (to be referred to as SRD) as a semiconductor element and is capable of obtaining a multiplication step of $n_2 = 4$ or so (that is the multiplier means can provide a frequency-multiplied output frequency of 8 GHz or so).

Figure 2 illustrates an example of the structure of multiplier means using a step recovery diode. In Figure 2, 61 is an input terminal and for example the input signal $f_o(= 2$ GHz) is input thereto. 62 is a resonant circuit, resonating with the input signal $f_o$. An output of the resonant circuit 62 is supplied to an SRD 64 via a small driving inductance 63 which is equivalently formed by a lead wire. On the other hand, a bias voltage $V_c$ is applied to the SRD 64 via a decreasing (voltage dropping) connector circuit comprising a resistor 65, a bypass capacitor 66 and a resistor 67. The SRD 64 is provided within a waveguide 68 and a multiplied signal generated by the SRD 64, for example, $4f_o(= 8$ GHz) can be extracted from a waveguide output 69. As seen, the waveguide is of uniform width, open at its output end, with the diode 64 mounted in the waveguide at its other end.

The step recovery diode suffers large changes in its equivalent capacitance depending the bias conditions. Namely, it exhibits a very small static capacitance $C_{VR}$, determined by its diode characteristics, under a backward bias condition, but it exhibits a large static capacitance $C_{FWD}$ under a forward bias condition. Usually, $C_{VR} = 0.5$ to 5 pF but $C_{FWD}$ can be so large as to approach infinity. In the circuit of Figure 2, the SRD 64 can be alternately biased forward and backward for each cycle of an input signal $f_o$ by applying suitable

bias vltage $V_c$. Under such conditions, when the SRD 64 is forward biased, energy is accumulated in the driving inductance 63, and when the SRD 64 is backward biased and static capacitance is switched from $C_{FWD}$ to $C_{VR}$, energy accumulated in such inductance is released. Thereby a narrow high frequency pulse is generated across the static capacitance $C_{VR}$.

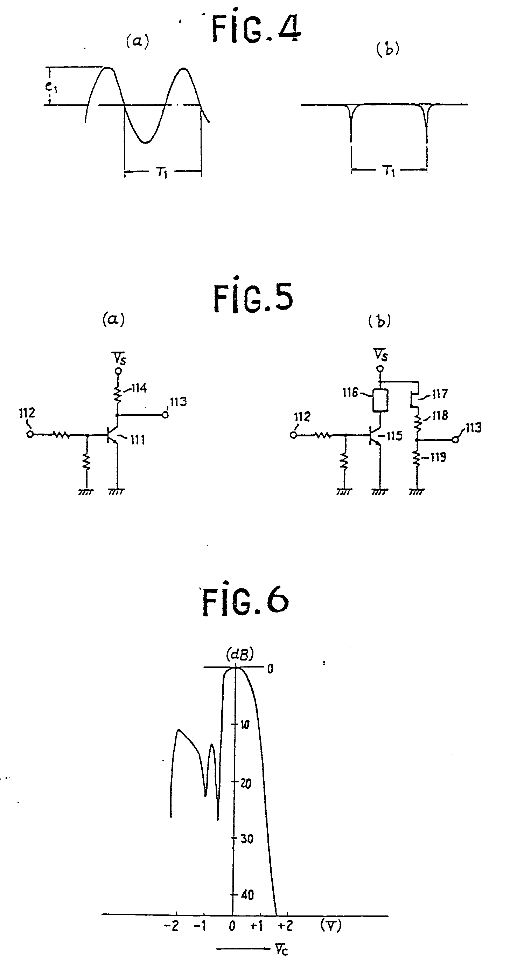

Figure 4 illustrates examples of waveforms of an input signal to the multiplier means and step recovery diode output. In Figure 4(a) shows the waveform of a signal $f_o$ applied to input terminal 61, which signal is substantially a sine wave with an amplitude $e_1$ and a period of $T_1$. On the other hand, (b) shows the output waveform of SRD 64 with the same period of $T_1$ and consisting of a sharp pulse. Such a sharp pulse waveform usually contains harmonics of higher orders and a multiplier means can be formed by extracting only a signal of a desired order from such harmonics. In Figure 2, 68 is a waveguide, equivalently forming a band-pass filter which resonates at the specified frequency band (desired higher order harmonic frequency). For example, only the quadrupled harmonic $4f_o(= 8$ GHz) is selected and can be extracted through the waveguide output. In the circuit of Figure 2, when a high frequency $f_o = 2.0$ GHz at a level of 20 dBm is input, for example, a higher frequency $(4f_o)$ output of about 15 dBm is obtained at a bias voltage $V_c = 0$.

Figure 3 shows an alternative multiplier means structure utilizing a step recovery diode, not using a waveguide in accordance with the invention. This structure may be used in a plane circuit formed using a micro-strip line. In Figure 3, the same reference numbers as are used in Figure 2 indicate similar elements.

In the structure of Figure 3, an idler 70 comprising LC series circuits having a specified resonant frequency is connected to a bias supplying means ($V_c$ is bias voltage). The idler 70 functions as a Band-Reject Filter (BRF) and reduces impedance for a specific frequency near the SRD 64. For example, the input signal $f_o(= 2$ GHz) sent from the input terminal 61 is input to the SRD 64 and the harmonic signals are extracted and input to the idler 70. The idler 70 comprises LC circuits which respectively resonate at frequencies of 4 GHz and 6 GHz and these specific frequency signals are reflected and enter again the SRD 64. The energy of these reflected signals is used again for extraction of a specified multiplied frequency signal, for example, $4f_o(= 8$ GHz), improving efficiency of operation.

A high frequency signal having passed through the idler 70 is input to a resonator circuit 71 for extraction of only the specified multiplied frequency signal. The resonator circuit 71 allows, for example, only the $4f_o$ signal (= 8 GHz) to pass and functions as a Band-Pass Filter. Namely, it plays the role of the waveguide 69 shown in Figure 2. The signal obtained from this resonator circuit 71 can pass, for example, to a coaxial cable line instead of an output terminal 72, as an output.

In the high frequency generator shown in Figure 1, the synchronism of PLL circuit is monitored by the monitoring circuit 8. As the monitoring circuit there can for example be used a circuit obtaining a synchronism detecting signal from a subtraction output through comparison between control voltage and reference voltage by utilizing, for example, the fact that the control voltage to be fed back to the VCO 1 via the loop filter 4 goes out of a specified voltage range under asynchronous conditions.

When a synchronism detecting signal is generated from the monitoring circuit 8, the bias control circuit 11 is controlled and thereby the multiplier means bias voltage ($V_c$) is changed. Figure 5(a) and (b) show examples of structures of bias voltage control circuits.

In Figure 5, (a) shows an example using a transistor. 111 is an NPN transistor which is in the cut-off condition when an input (synchronism detecting) signal is not applied from an input terminal 112, which provides that a positive voltage is generated at an output terminal 113 from a power source $V_s$ via a resistor 114. On the other hand, when the synchronism detecting signal is applied to the terminal 112, the transistor 111 becomes conductive and its collector voltage becomes almost 0V and therefore the output terminal 113 is set to ground potential. Thereby, the bias voltage of multiplier means changes.

In Figure 5, (b) shows as example using a relay in place of a transistor. When there is no input at the terminal 112, an NPN transistor 115 is in the cut-off condition, making the relay 116 inoperative. Therefore, a contact 117 closes and a positive voltage is generated at the output terminal 113 from the power source $V_s$ via a voltage dividing circuit consisting of resistors 118 and 119. When a synchronism detecting signal is applied to the terminal 112, the transistor 115 becomes conductive, the relay 116 operates, the contact 117 opens and the terminal 113 is set to the ground potential.

Meanwhile, an oscillation output is being applied from the VCO 1 to the multiplier means 6, in addition to the bias voltage, as explained previously. Therefore, when the bias voltage $V_c$ becomes higher in level than the amplitude of the oscillation output $e_1$, SRD 64 is always in a conductive condition and switching between static capacitances $C_{FWD}$ and $C_{VR}$ is no longer performed at the SRD 64 and as a result the multiplication operation stops. In each circuit of Figure 5, if a negative bias voltage output is obtained when the synchronism detecting signal is not applied and if the bias voltage level is higher than the oscillation amplitude $e_1$, the SRD 64 is always in the cut-off condition. In the same way, switching between static capacitances $C_{VR}$ and $C_{FWD}$ is no longer carried out in the SRD 64 and multiplication operation stops.

Figure 6 is a graph showing an example of an output characteristic in such a case in which the bias voltage of multiplier means is changed. In the graph, the horizontal axis indicates bias voltage $V_c$, whilst the vertical axis indicates reduction of multiplier means output resulting from changes of bias voltage $V_c$ with reference (0 dB) to Vc=0. Namely, in a range of change of bias voltage $V_c$ of about +0.2 V around 0, multiplier means output voltage changes little. In the ranges of +1 V or more or −2.2 V or less, it has been confirmed that multiplier means output is zero or very small.

According to the above-described embodiments, an output of a high frequency generator, comprising generating means and multiplier means containing a diode for multiplying an output frequency of said generating means, can be kept off or reduced by suspending or suppressing multiplying operation through the control of bias voltage of a step recovery diode used in the multiplier means.

Therefore, in a microwave generator embodying this invention, a high frequency output can be cut off by controlling a generator using multiplier means. Circuit structure can be simplified and a sufficiently large output attenuation can be realized by perfectly suspending the operation of multiplier means. From this point of view, output of a device is very effectively kept 'off'.

In addition, the above-described embodiments of this invention have used only a method of controlling microwave output with a synchronism detecting signal sent from a PLL, but embodiments of this invention, for example microwave generators, can provide for control of an output signal by means of a control signal from an external circuit.

An embodiment of this invention provides a high frequency generator comprising generating means and multiplier means including a step recovery diode which multiplies the output frequency of the generating means. Output is turned off or reduced by suspending or suppressing multiplying operation through control of bias voltage to be applied to the diode used in the multiplier means. This system for cutting off the output by controlling the multiplier means is very effective, simplifying structure and reliably switching off the output.

**Claims**

1. A high frequency generator, comprising generating means (1, 2, 3, 4, 5) for generating a signal of a first frequency, and multiplier means (6; 61 to 69), having an input terminal (61) operatively connected to the generating means, for providing a frequency-multiplied signal, of a second frequency, from the signal of the first frqeuency, the multiplier means comprising a diode (64), operatively connected to the input terminal (61), for providing harmonic frequency signals, including a signal of the second frequency, from said signal of the first frequency, bias voltage control means (11; 65, 66, 67; 111 to 114; 112, 113, 115 to 119) for controlling bias voltage applied to the diode, and output means (68) characterised in that the diode is a step recovery diode,

the bias voltage control means operate to turn off selectively the frequency-multiplied signal, by turning off the step recovery diode so that it no longer provides harmonic frequency signals including a signal of the second frequency, and in that

the output means (68) is a waveguide of uniform width, open at one end, having a specified resonant frequency, with the step recovery diode mounted in the waveguide at its other end.

2. A generator according to claim 1, wherein the generating means comprise:

a voltage controlled oscillator (1);

a reference signal generator (3);

mixing means (2), operatively connected to outputs of each of the voltage controlled oscillator and the reference signal generator, for mixing output signals therefrom, to provide an output signal in accordance with a phase-difference between the mixed signals; and

a loop-filter (4) connected to the output of the mixing means and to an input of the voltage controlled oscillator, whereby the voltage controlled oscillator generates its output signal under the control of a signal supplied via the loop-filter.

3. A generator according to claim 2, wherein the mixing means (2) is a harmonic mixer circuit which outputs a signal in proportion to the difference between the output signal of the voltage controlled oscillator (1) and a harmonic signal of the reference signal (3).

4. A generator according to claim 2 or 3, further comprising a monitoring circuit (8), operatively connected to the output of the mixing meanms (2), for monitoring synchronism between the reference signal and the output signal of the voltage controlled oscillator (1), operable to provide an alarm to the bias voltage control means (11) when the monitoring circuit does not detect such synchronism.

5. A generator according to any preceding claim, wherein the multiplier means further comprise:

a resonator circuit (62), connected to the input terminal (61) of multiplier means and to the step recovery diode (64), for resonating at a specified frequency, whereby an output of the resonator circuit determines a signal frequency which is supplied to the diode (64); and

a driving inductance (63), connected to the resonator circuit (62) and to the diode (64), for driving the diode to provide said harmonic frequency signals.

**Patentansprüche**

1. Hochfrequenzgenerator, mit einer
Generatoreinrichtung (1, 2, 3, 4, 5) zum Generieren eines Signals einer ersten Frequenz, und einer
Vervielfachereinrichtung (6; 61 bis 69), die einen Eingangsanschluß (61) hat, der wirkungsmäßig mit der Generatoreinrichtung verbunden ist, um, aus dem Signal der ersten Frequenz, ein frequenz-multipliziertes Signal von einer zweiten Frequenz zu liefern, welche Vervielfachereinrichtung eine Diode (64) umfaßt, die wirkungsmäßig mit dem Eingangsanschluß (61) verbunden ist, um aus dem genannten Signal der ersten Frequenz harmonische Frequenzsignale zu liefern, einschließlich eines Signals der zweiten Frequenz, einer Vorspannungs-Steuereinrichtung (11; 65, 66, 67; 111 bis 114; 112, 113, 115 bis 119), zum Steuern der Vorspannung, die der Diode zugeführt wird, und einer Ausgangseinrichtung (68), dadurch gekennzeichnet, daß

die Diode eine Speicherschaltdiode ist,

die Vorspannungs-Steuereinrichtung im Betrieb selektiv das frequenz-multiplizierte Signal ausschaltet, durch Ausschalten der Speicherschaltdiode, so daß sie nicht mehr harmonische Frequenzsignale einschließlich eines Signals der zweiten Frequenz liefet, und daß

die Ausgangseinrichtung (68) ein Wellenleiter von gleichförmiger Breite ist, an einem Ende offen, welcher eine spezifizierte Resonanzfrequenz hat, mit der Speicherschaltdiode in dem Wellenleiter an seinem äußeren Ende montiert.

2. Generator nach Anspruch 1, bei dem die Generatoreinrichtung umfaßt:

einen spannungsgesteuerten Oszillator (1);

einen Referenzsignalgenerator (3);

eine Mischeinrichtung (2), die wirkungsmäßig mit den Ausgängen sowohl des spannungsgesteuerten Oszillators als auch des Referenzsignalgenerators verbunden ist, um Ausgangssignale von diesen zu mischen, um ein Ausgangssignal in Übereinstimmung mit einer Phasendifferenz zwischen den gemischten Signalen zu liefern; und

ein Schleifenfilter (4), das mit dem Ausgang der Mischeinrichtungen und einem Eingang des spannungsgesteuerten Oszillators verbunden ist, wodurch der spannungsgesteuerte Oszillator ein Ausgangssignal unter der Steuerung eines über den Schleifenfilter zugeführten Signals erzeugt.

3. Generator nach Anspruch 2, bei dem die Mischeinrichtung (2) eine harmonische Mischschaltung ist, welche ein Signal in Proportion zu der Differenz zwischen dem Ausgangssignal des spannungsgesteuerten Oszillators (1) und einem harmonischen Signal des Referenzsignals (3) ausgibt.

4. Generator nach Anspruch 2 oder 3, ferner mit einer Monitorschaltung (8), die wirkungsmäßig mit dem Ausgang der Mischeinrichtung (2) verbunden ist, um den Synchronismus zwischen dem Referenzsignal und dem Ausgangssignal des spannungsgesteuerten Generators (1) zu überwachen, die betreibbar ist, um einen Alarm zu der Vorspannungs-Steuereinrichtung (11) zu liefern, wenn die Monitorschaltung solch einen Synchronismus nicht feststellt.

5. Generator nach einem der vorhergehenden Ansprüche, bei der die Vervielfachereinrichtung ferner umfaßt:

eine Resonatorschaltung (62), die mit dem Eingangsanschluß (61) der Vervielfachereinrichtung und der Speicherschaltdiode (64) verbunden ist, um mit einer spezifizierten Frequenz zu schwingen, wodurch ein Ausgang der Resonatorschaltung eine Signalfrequenz bestimmt, welche der Diode (64) zugeführt wird; und

einer treibenden Induktans (63), die mit der Resonatorschaltung (62) und der Diode (64) verbunden ist, um die Diode zu treiben, um die genannten harmonischen Frequenzsignale zu liefern.

## Revendications

1. Générateur haute fréquence, comprenant:

un moyen générateur (1, 2, 3, 4, 5) pour engendrer un signal d'une première fréquence, et

un moyen multiplicateur (6; 61 à 69), ayant une borne d'entrée (61) connectée activement au moyen générateur, pour fournir un signal de fréquence multpliée, d'une deuxième fréquence, à partir du signal de la première fréquence, le moyen multiplicateur comprenant une diode (64), connectée activement à la borne d'entrée (61), pour fournir des signaux de fréquences d'harmoniques, y compris un signal de la deuxième fréquence, à partir du signal de la première fréquence, un moyen de réglage de tension de polarisation (11; 65, 66, 67; 111 à 114; 112, 113, 115 à 119) pour régler la tension de polarisation appliquée à la diode, et un moyen de sortie (68), caractérisé en ce que:

la diode est une diode de rétablissement pas-à-pas,

le moyen de réglage de tension de polarisation fonctionne pour couper sélectivement le signal de fréquence multpliée, en bloquant la diode de rétablissement pas-à-pas de sorte qu'elle ne fournisse plus des signaux de fréquences d'harmoniques y compris un signal de la deuxième fréquence, et en ce que

le moyen de sortie (68) est un guide d'ondes de largeur uniforme, ouvert à une extrémité, ayant une fréquence de réonance spécifiée, la diode de rétablissement pas-à-pas étant montée dans le guide d'ondes à son autre extrémité.

2. Générateur selon la revendication 1, dans lequel le moyen générateur comprend:

un oscillateur à fréquence réglée par variation de tension (1);

un générateur de signaux de référence (3);

un moyen mélangeur (2), connecté activement aux sorties respectivement de l'oscillateur à fréquence réglée par variation de tension et du générateur de signaux de référence, pour mélanger les signaux de sortie de ceux-ci, afin de fournir un signal de sortie conformément au déphasage entre les signaux mélangés; et

un filtre de boucle (4) connecté à la sortie du moyen mélangeur et à une entrée de l'oscillateur à fréquence réglée par variation de tension, l'oscillateur à fréquence réglée par variation de tension engendrant de la sorte son signal de sortie sous la commande d'un signal fourni par le filtre de boucle.

3. Générateur selon la revendication 2, dans lequel le moyen mélangeur (2) est un circuit mélangeur d'harmoniques qui engendre en sortie un signal proportionnellement à la différence entre le signal de sortie de l'oscillateur à fréquence réglée par variation de tension (1) et un signal d'harmonique du signal de référence (3).

4. Générateur selon l'une quelconque des revendications 2 et 3, comprenant en outre un circuit de contrôle (8), connecté activement à la sortie du moyen mélangeur (2), pour contrôler le synchronisme entre le signal de référence et le siganl de sortie de l'oscillateur à fréquence réglée par variation de tension (1), pouvant être mis en fonctionnement pour fournir un avertissement au moyen de réglage de tension de polarisation (11) quand le circuit de contrôle ne détecte pas ce synchronisme.

5. Générateur selon l'une quelconque des revendications 1 à 4, dans lequel le moyen multiplicateur comprend en outre:

un circuit résonnant (62), connecté à la borne d'entrée (61) du moyen multiplicateur et à la diode de rétablissement pas-à-pas (64), pour résonner à une fréquence spécifiée, un signal de sortie du circuit résonnant déterminant ainsi la fréquence de signal qui est fournie à la diode de rétablissement pas-à-pas (64); et

un bobinage d'excitation (63), connecté au circuit résonnant (62) et à la diode (64), pour exciter la diode afin qu'elle fournisse les signaux de fréquences d'harmoniques.

# FIG.1

# FIG.2

# FIG.3

1

# FIG.4

(a)

(b)

$e_1$

$T_1$

$T_1$

# FIG.5

(a)

(b)

$V_S$

114

113

112

111

$V_S$

116

117

118

112

115

113

119

# FIG.6

(dB)

0

10

20

30

40

-2  -1  0  +1  +2  (V)

$V_C$

2